(19) Europäisches Patentamt
European Patent Office
Office européen des brevets

(11) EP 0 936 739 A1

(12) **EUROPÄISCHE PATENTANMELDUNG**

(43) Veröffentlichungstag:
18.08.1999 Patentblatt 1999/33

(51) Int. Cl.⁶: **H03K 17/95**

(21) Anmeldenummer: 98810127.5

(22) Anmeldetag: 17.02.1998

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(71) Anmelder: **Optosys SA**
**1762 Givisiez (CH)**

(72) Erfinder: **Heimlicher, Peter**
**1700 Freiburg (CH)**

(74) Vertreter:
**AMMANN PATENTANWAELTE AG BERN**
**Schwarztorstrasse 31**
**3001 Bern (CH)**

(54) **Induktiver Näherungsschalter**

(57)  Induktiver Näherungsschalter mit einer Spule, Mitteln zum Speisen der Spule mit einem periodischen Sendestrom der Periode T, und Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert werden.

Zur Verbesserung der Eigenschaften des Näherungsschalters ist dieser dadurch gekennzeichnet, dass

(a) die Speisemittel dazu eingerichtet sind, der Spule (11) Sendestromimpulse zu liefern, deren Richtung periodisch wechselt, wobei jeweils

(b) in der ersten Hälfte einer Periode T der durch die Speisemittel an die Spule abgegebene Sendestrom in einer ersten Richtung und im wesentlichen nur während eines ersten Intervalls der Dauer T1 fliesst, die kleiner als T/2 ist, anschliessend während einem Zeitintervall (T1') abklingt und während der Restzeit (T2-T1') der ersten Hälfte der Periode T vernachlässigbar klein ist, und

(c) in der zweiten Hälfte der Periode T der durch die Speisemittel an die Spule abgegebene Sendestrom in einer der ersten entgegengesetzten Richtung und im wesentlichen nur während eines zweiten Intervalls der Dauer T3 fliesst, das kleiner als T/2 ist, anschliessend während einem Zeitintervall (T3') abklingt und während der Restzeit (T4-T3') der zweiten Hälfte der Periode T vernachlässigbar klein ist.

Fig. 1

## Beschreibung

Die Erfindung betrifft einen induktiven Näherungsschalter mit

- einer Spule,
- Mitteln zum Speisen der Spule mit einem periodischen Sendestrom der Periode T, und
- Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert werden.

Das Prinzip eines Näherungsschalters der oben erwähnten Art ist aus der EP-A-0492029 B1 bekannt. Bei diesem Näherungsschalter werden unipolare Spannungsimpulse an die Spule 11 gelegt. Als Nutzsignal wird mit einer geeigneten Schaltung die Spannung erfasst, die nach dem Ende eines Sendestromimpulses durch den in dem zu erfassenden Körper, der aus einem elektrisch leitfähigen Material besteht, fliessenden abklingenden Strom, der dort vorher infolge der durch die vom Sendestromimpuls induzierten Spannung fliesst, in der Spule 11 induziert wird.

Der aus der EP-A-0492029 B1 bekannte Näherungsschalter hat folgende Nachteile:

- Störende eingestreute niederfrequente Magnetfelder überlagern dem Nutzsignal ein Störsignal, dessen Amplitude sehr erheblich sein kann und beeinträchtigen damit das Schaltverhalten des Näherungsschalters.
- Da das Nutzsignal mit einem erheblichen Störsignalanteil behaftet sein kann, ist es zweckmässig, es nur über ein relativ kurzes Zeitfenster zu integrieren, damit das Störsignal gegen Ende der Periode T mit einem zweiten kurzen Zeitfenster erfasst werden kann. Das resultierende Nutzsignal ist daher relativ schwach. Die Wahl der geeigneten Lage und Dauer der soeben erwähnten Zeitfenster ist nicht einfach und bedingt einen Kompromiss zu Lasten der Leistungsfähigkeit des Sensors.
- Aus den oben genannten Gründen steht das Nutzsignal nur während eines relativen kleinen Teils seiner Gesamtdauer zur weiteren Verarbeitung zur Verfügung, was die Leistungsfähigkeit des Sensors weiter beeinträchtigt.
- Der unipolare Charakter der Sendeimpulse bedingt, dass bei jeder Periode T mit dem nächsten Sendeimpuls solange zugewartet werden muss, bis der von der in dem zu erfassenden Körper induzierte Spannung verursachte Strom fast vollständig abgeklungen ist. Andernfalls kommt es zu einer Kumulation von Strömen im zu erfassenden Körper, wodurch die Qualität des Empfangssignals beeinträchtigt wird. Die genannte Wartezeit bedingt eine niedrige Taktfrequenz, wodurch die maximale Schaltfrequenz des Gerätes reduziert wird.
- Schaltungsmässig erfordert die Beseitigung von Verstärkeroffsetspannungen infolge der Gleichspannungskomponente im Empfangssignal einen Mehraufwand.

Der Erfindung liegt die Aufgabe zugrunde, einen induktiven Näherungsschalter der eingangs erwähnten Art zu konzipieren, mit dem die oben erwähnten Nachteile beseitigt werden.

Erfindungsgemäss wird diese Aufgabe mit einem induktiven Näherungsschalter der eingangs erwähnten Art gelöst, der durch die im kennzeichnenden Teil des Patentanspruchs 1 definierten Merkmale gekennzeichnet ist.

Mit einem erfindungsgemässen induktiven Näherungsschalter werden insbesondere folgende Vorteile erzielt:

- Die störende Wirkung von eingestreuten niederfrequenten Magnetfeldern lässt sich fast vollständig eliminieren. Der Störabstand des Nutzsignals und damit die Zuverlässigkeit des Schaltverhaltens des Näherungsschalters werden daher erheblich erhöht.
- Das Nutzsignal wird durch nur ein Zeitfenster erfasst, das zudem den überwiegenden Teil von dessen Dauer umfasst. Dadurch steigt die Qualität des zur Weiterverarbeitung zur Verfügung stehenden Signals.
- Da das Abklingen des Nutzsignals nicht abgewartet werden muss, kann die Taktfrequenz und damit die nutzbare Schaltfrequenz des Näherungsschalters erhöht werden.
- Die Polarität der Sendestromimpulse wechselt bei jedem Impuls. Dadurch kann sich auch bei kurzer Periode T keine störende Stromakkumulation im zu erfassenden Körper einstellen.
- Bei der Ermittlung der geeigneten Lage und Dauer des oben erwähnten Zeitfensters muss kein Kompromiss eingegangen werden. Ein Zeitfenster, das eine optimale Abstimmung des Schaltabstandes für verschiedene Metalle ermöglicht, z.B. Stahl und Aluminium, kann frei gewählt werden.
- Die soeben erwähnten verbesserten Eigenschaften des Nutzsignals ermöglichen eine erhebliche Erhöhung des Schaltabstandes.
- Der Schaltungsaufwand im Verstärkerteil ist kleiner, weil infolge von Wechselspannungskopplung ein Mehraufwand zur Beseitigung von Verstärkeroffsetspannungen nicht erforderlich ist.

Ein Ausführungsbeispiel der Erfindung wird im folgenden anhand der beiliegenden Figuren 1 bis 4 erläutert.

Figur 1     Zeigt ein Blockschaltbild der elektronischen Schaltung eines erfindungsgemässen Näherungsschalters,

Figur 2     zeigt Diagramme des Verlaufs der Steuersignale, von Spannungen, die an der in Figur 1 dargestellten Spule 11 messbar sind, und des durch diese Spule fliessenden Stroms,

Figur 3     zeigt im Detail den Aufbau der Brückenschaltung 14 in Fig. 1 und Teile des Impulsgenerators 15 und des Eingangsverstärkers 17,

Figur 4     zeigt einen schematischen Querschnitt eines Näherungsschalters, in dem die Schaltung gemäss Fig. 1 enthalten ist.

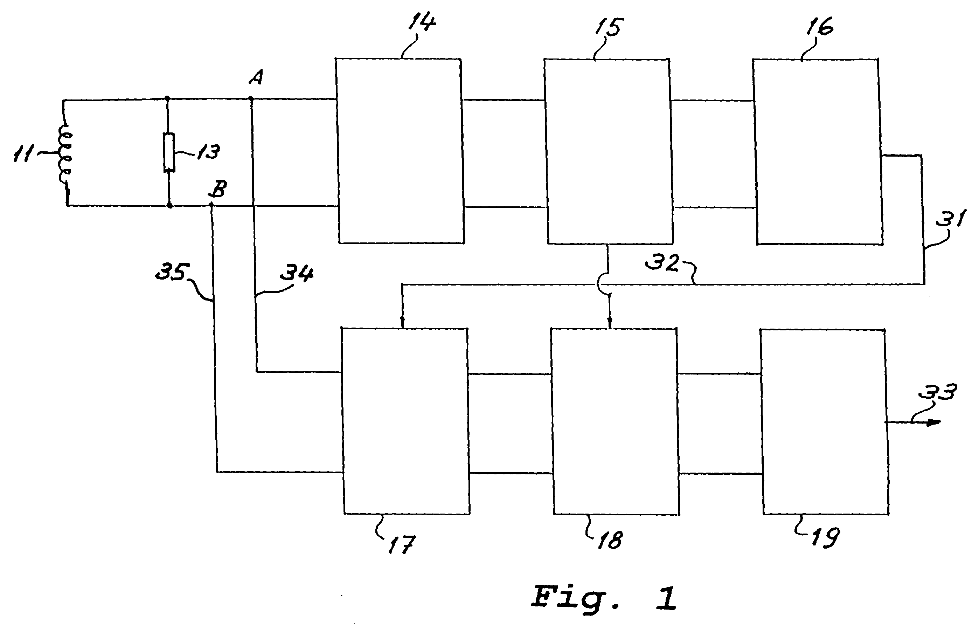

Wie in Fig. 1 schematisch dargestellt, enthält ein erfindungsgemässer Näherungsschalter eine Spule 11, die über eine gesteuerte Brückenschaltung 14 mit einem Impulsgenerator 15 verbunden ist. Ein Widerstand 13 ist parallel zur Spule geschaltet. Dieser Widerstand dient als Dämpfungswiderstand.

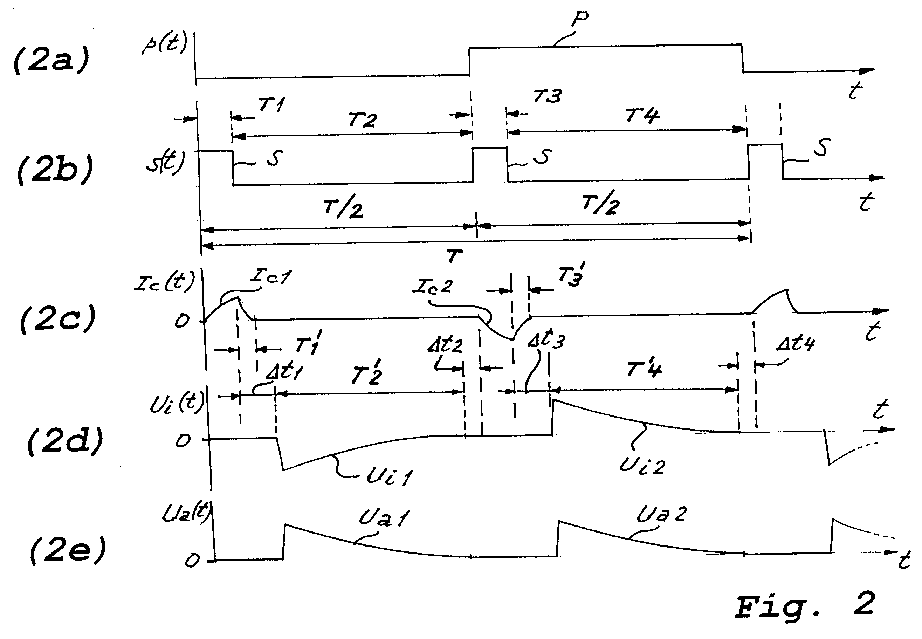

Die Diagramme 2a und 2b der Fig. 2 zeigen die Steuersignale $p(t)$ und $s(t)$, mit welchen der Impulsgenerator 15 die Funktion der Brückenschaltung 14 steuert. Das Steuersignal $p(t)$ steuert die Polarität der Brücke, das Steuersignal $s(t)$ besteht aus periodischen Impulsen, die eine Dauer T1 bzw. T3 haben. Die Periode des Steuersignals ist T.

Die Dauer von T beträgt typischerweise 320 Mikrosekunden, diejenige von T1 und T3 20 Mikrosekunden.

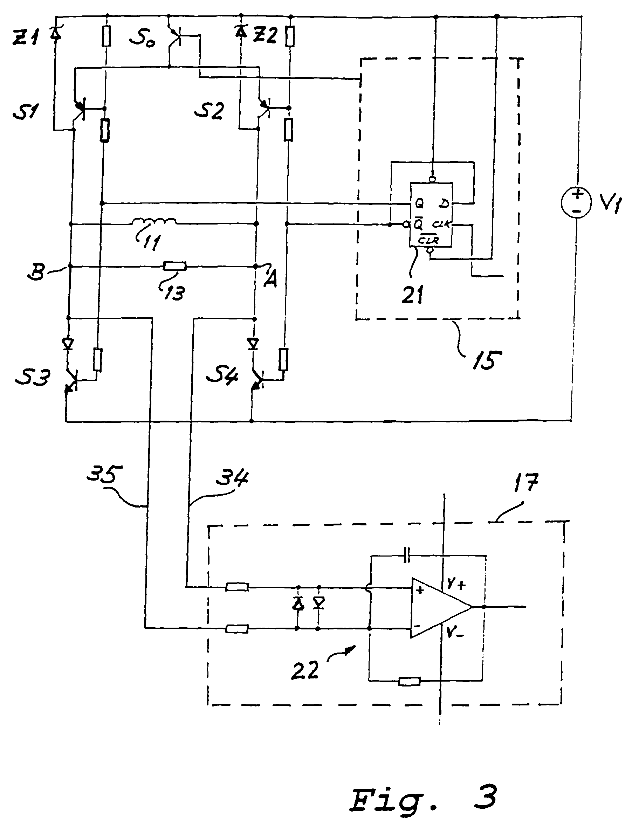

Die Steuerung der Brückenschaltung 14 während einer Periode T ist nachstehend anhand der Fig. 2 und 3 beschrieben. Durch ein vom Impulsgenerator 15 geliefertes Polaritätssignal P (Diagramm 2a) werden zu Beginn von T die Schalter S1 und S4 geschlossen, S2 und S3 geöffnet. Gleichzeitig wird durch einen Steuerimpuls S (Diagramm 2b) während eines Intervalls T1 der Schalter S0 geschlossen. Dadurch verbindet die Brückenschaltung 14 während dieses Intervalls T1 die Anschlüsse A, B in Fig. 3 mit den Anschlüssen einer Gleichspannungsquelle V1 derart, dass dadurch an die Spule 11 eine Gleichspannung +V1 angelegt wird.

Während des Intervalls T1 fliesst deshalb ein Strom Ic1 (Diagramm 2c) durch die Spule 11.

Am Ende von T1 wird durch das Signal S der Schalter S0 während des Intervalls T2 wieder geöffnet und damit die Spule 11 von der Spannungsquelle V1 getrennt. Der in der Spule 11 fliessende Strom Ic1 klingt während des Intervalls T1' über die Zenerdiode Z1 auf Null ab. Am Ende dieses Intervalls T1' und bis zum Ende des Intervalls T2 bleibt der Punkt A über S4 mit dem negativen Pol von V1 verbunden, während Punkt B weder über S1 noch über Z1 mit V1 verbunden und somit nur noch über die Verbindung 35 mit der hohen Eingangsimpedanz des Verstärkers 22 belastet ist.

In der Mitte von T, d.h. nach der Zeit T1 + T2, werden durch das vom Impulsgenerator 15 gelieferte Polaritätssignal P (Diagramm 2a) die Schalter S2 und S3 geschlossen, S1 und S4 geöffnet. Gleichzeitig wird durch einen weiteren Steuerimpuls S (Diagramm 2b) während eines Intervalls T3 der Schalter S0 geschlossen. Dadurch verbindet die Brückenschaltung 14 während dieses Intervalls T3 die Anschlüsse A, B in Fig. 3 mit den Anschlüssen einer Gleichspannungsquelle V1 derart, dass dadurch an die Spule 11 eine Gleichspannung -V1 angelegt wird.

Während des Intervalls T3 fliesst deshalb ein Strom Ic2 (Diagramm 2c) durch die Spule 11.

Am Ende von T3 wird durch das Signal S der Schalter S0 während des Intervalls T4 wieder geöffnet und damit die Spule 11 von der Spannungsquelle V1 getrennt. Der in der Spule 11 fliessende Strom Ic2 klingt während des Intervalls T3' über die Zenerdiode Z2 auf Null ab. Am Ende dieses Intervalls T3' und bis zum Ende des Intervalls T4 bleibt der Punkt B über S3 mit dem negativen Pol von V1 verbunden, während Punkt A weder über S2 noch über Z2 mit V1 verbunden und somit nur noch über die Verbindung 34 mit der hohen Eingangsimpedanz des Verstärkers 22 belastet ist.

Durch Wiederholung des soeben beschriebenen Vorgangs wird die Spule 11 abwechselnd mit positiven und negativen Stromimpulsen beaufschlagt.

Wie soeben beschrieben, sind in einem erfindungsgemässen Näherungsschalter die Mittel zum Speisen der Spule 11 mit einem periodischen Sendestrom so eingerichtet, dass sie die Spule 11 mit periodischen Stromimpulsen beaufschlagen, deren Richtung periodisch wechselt, wobei:

-     in der ersten Hälfte einer Periode T der durch die Speisemittel an die Spule abgegebene Sendestrom in einer ersten Richtung und im wesentlichen nur während eines ersten Intervalls der Dauer T1 fliesst, die kleiner als T/2 ist, anschliessend während der Zeit T1' abklingt und während der Restzeit T2-T1' der ersten Hälfte der Periode T vernachlässigbar klein ist, und

-     in der zweiten Hälfte der Periode T der durch die Speisemittel an die Spule abgegebene Sendestrom in einer der ersten entgegengesetzten Richtung und im wesentlichen nur während eines zweiten Intervalls der Dauer T3 fliesst, die kleiner als T/2 ist, anschliessend während der Zeit T3' abklingt und während der Restzeit T4 der zweiten Hälfte der Periode T vernachlässigbar klein ist.

Die Intervalle T1 bzw. T3 sind vorzugsweise wesentlich kleiner als die Hälfte der Periode T, wobei es vorteilhaft ist, T1 = T3 zu wählen, wie in Fig. 2b dargestellt.

Die Periode T des Steuersignals gemäss Diagramm 2a der Fig. 2 und der Sendestromimpulse gemäss Diagramm 2c umfasst die vier Intervalle T1, T2, T3, T4, wobei T = T1 + T2 + T3 + T4 ist.

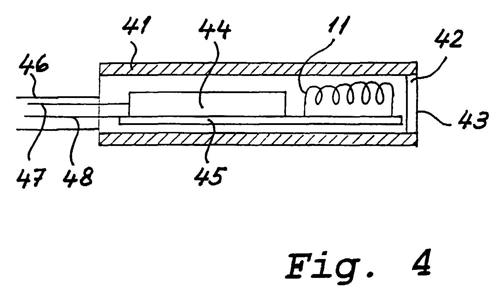

Der oben beschriebene Stromverlauf in der Spule 11 erzeugt in der Umgebung der Spule 11 ein variables magnetisches Feld. Wie aus Fig. 4 ersichtlich, wird die Spule 11 so ausgerichtet, dass das genannte Feld durch die aktive Fläche 43 des Näherungsschalters austritt.

Wenn ein zu erfassender Körper sich im Einflussbereich dieses variablen magnetischen Feldes befindet, werden in diesem Körper ein Spannungen induziert. Diese Spannungen erzeugen durch magnetische Kopplung ihrerseits induzierte Spannungen Ui in der Spule 11. Diese induzierten Spannungen sind im Diagramm 2d der Fig. 2 dargestellt. Die durch die Sendestromimpulse an der Spule 11 entstehenden Spannungen sind hier nicht dargestellt.

Die negative induzierte Spannung Ui1 wird von Strömen im erfassten Körper hervorgerufen, welche auf den positiven Sendestromimpuls Ic1 zurückzuführen sind, der während des Intervalls der Dauer T1 durch die Spule 11 fliesst.

Die positive induzierte Spannung Ui2 wird von Strömen im erfassten Körper hervorgerufen, welche auf den negativen Sendestromimpuls Ic2 zurückzuführen sind, der während des Intervalls der Dauer T3 durch die Spule 11 fliesst.

Wie nachstehend im Detail beschrieben, stehen die in der Spule 11 induzierten Spannungen Ui1, Ui2 etc., welche in den Baugruppen 17, 18 und 19 der Fig. 1 als Nutzsignal ausgewertet werden, zwischen den Anschlüssen A und B in Figur 1 und 3 an. Diesem Nutzsignal können Spannungen überlagert sein, die durch Streufelder in der Spule 11 induziert werden. Solche Störsignale sind in der Darstellung der induzierten Spannungen Ui1, Ui2, etc. im Diagramm 2d der Fig. 2 nicht gezeigt.

Die Anschlüsse A und B sind über die Leitungen 34 und 35 mit den Eingängen eines Eingangsverstärkers 17 verbunden. Diesem Verstärker ist ein Polaritätsschalter 18 nachgeschaltet, der, gesteuert durch das Steuersignal p(t), das an seinem Eingang anstehende Signal entweder invertiert oder nicht invertiert. Diesem Polaritätsschalter folgt ein Tiefpassfilter 19.

Die im Diagramm 2d der Fig. 2 dargestellten, in der Spule 11 induzierten Spannungen Ui1, Ui2, etc. werden dem Eingangsverstärker 17 zugeführt und dort wie folgt erfasst bzw. verarbeitet:

Während eines ersten Zeitfensters T2' wird die induzierte Spannung Ui1 vom Eingangsverstärker 17 als ein erstes Eingangssignal empfangen und dort verstärkt. Das Zeitfenster T2' beginnt nach dem Ende des Sendestromeimpulses Ic1 und liegt innerhalb der Restzeit der Dauer T2-T1' in der ersten Hälfte der Periode T.

Während eines zweiten Zeitfensters T4' wird die induzierte Spannung Ui2 vom Eingangsverstärker 17 als ein zweites Eingangssignal empfangen und dort verstärkt. Das Zeitfenster T4' beginnt nach dem Ende des Sendestromimpulses Ic2 und liegt innerhalb der Restzeit der Dauer T4-T3' in der zweiten Hälfte der Periode T.

Die zeitliche Lage und die Dauer des ersten Zeitfensters T2' und des zweiten Zeitfensters T4' werden von einer in Fig. 1 gezeigten Empfangsfenstersteuerung 16 über eine Leitung 31 gesteuert. Die Empfangsfenstersteuerung 16 wird ihrerseits von weiteren Steuersignalen gesteuert, die auch vom Impulsgenerator 15 geliefert werden.

In einer bevorzugten Ausführungsform beginnt das erste Zeitfenster T2' mit einer Verzögerung von Δt1 nach dem Beginn des Intervalls T2. Es endet gleichzeitig mit T2, d.h. mit Δt2 gleich Null. Das zweite Zeitfenster T4' beginnt mit einer Verzögerung von Δt3 nach dem Beginn des Intervalls T4. Es endet gleichzeitig mit T4, d.h. mit Δt4 gleich Null. Vorzugsweise haben das erste und das zweite Zeitfenster annähernd die gleiche Dauer T2' = T4'.

Die am Ausgang des Verstärkers 17 abgegebenen, verstärkten Signale Ui1, Ui2, etc. werden dem Eingang des Polaritätsschalters 18 zugeführt. Die Signale Ui1, Ui2 enthalten als zusätzliches Störsignal die Offsetspannung des Verstärkers 17.

Der Polaritätsschalter 18 wird von periodischen Steuerimpulsen der Periode T/2 umgeschaltet, um die Eingangssignale Ui1, Ui2, etc. während eines der entsprechenden Zeitfenster T2', T4' etc. zu invertieren bzw. nicht zu invertieren. Auf diese Weise wird mit dem Polaritätsschalter 18 aus der Impulsfolge Ui1, Ui2, etc. als Eingangssignal eine Impulsfolge als Ausgangssignal abgeleitet, die aus einer Folge von Spannungsimpulsen Ua1, Ua2, etc. gleicher Polarität besteht.

Das Ausgangssignal des Polaritätsschalter 18 wird mittels eines Tiefpassfilters 19, das als Mittelwertbildner wirkt, geglättet, um ein Ausgangssignal zu erzeugen, welches das Vorhandensein eines zu erfassenden Körpers signalisiert. Durch die selektive Invertierung der negativen Nutzsignale, wie z.B. Ui1, durch den Polaritätsschalter 18 und die darauffolgende Mittelung und Glättung mittels des Tiefpassfilters 19 werden Verstärkeroffsetspannungen und durch Streufelder in der Spule 11 induzierte Störspannungen periodisch invertiert und durch die Mittelung und Glättung im Tiefpassfilter 19 weitgehend eliminiert. Am Ausgang des Tiefpassfilters erhält man daher ein Nutzsignal mit einem wesentlich verbesserten Störsignalabstand. Dies ermöglicht eine bedeutende Erhöhung des Schaltabstands des Näherungsschalters.

Figur 3 zeigt im Detail den Aufbau der Brückenschaltung 14 in Fig. 1 und Teile des Impulsgenerators 15 und des Eingangsverstärkers 17. Angesteuert durch Ausgangssignale des Impulsgenerators 15 und insbesondere durch Signale an den Ausgängen eines im Impulsgenerator 15 enthaltenen Flipflops 21 (in Fig. 3 ist vom Impulsgenerator 15 davon nur Flipflop 21 dargestellt) werden die Transistorengruppen S0, S2, S3 bzw. S0, S1, S4 abwechselnd in leitenden Zustand versetzt. Dadurch wird wie oben bereits anhand der Fig. 2 beschrieben während den Intervallen T1 bzw. T3 eine Gleichspannung +V1 bzw. -V1 an die Spule 11 gelegt.

Wie in Fig. 3 gezeigt, werden die oben erwähnten und im Diagramm 2d der Fig. 2 dargestellten induzierten Spannungen Ui1, Ui2, etc. über Leitungen 34, 35 einer Eingangsstufe 22 des Eingangsverstärkers 17 zugeführt (in Fig. 3 ist vom Eingangsverstärker 17 nur die Eingangsstufe 22 dargestellt).

Figur 4 zeigt einen schematischen Querschnitt eines Näherungsschalters, in dem eine Schaltung gemäss Fig. 1 enthalten ist. Wie aus Fig. 4 ersichtlich, sind alle Komponenten des Näherungsschalters in einem Gehäuse 21 angeordnet, welches in an sich bekannter Weise im wesentlichen aus einem metallischen Zylinder 41 und aus einer Kappe 42 aus einem Kunststoff besteht. Die Kappe schliesst das Ende des Zylinders 41 ab. Die Aussenfläche 43 der Kappe 42 bildet die aktive Fläche des Näherungsschalters 11, welche im Betrieb dem zu erfassenden Körper zugewandt ist.

In Figur 4 stellt der Block 44 alle in Figur 1 dargestellten Komponenten des Näherungsschalters mit Ausnahme der Spule 11 dar. Die Spule 11 und alle Komponenten des Blocks 44 sind beispielsweise auf eine gedruckte Leiterplatte 45 montiert. Der Block ist über Leitungen 47 und 48 eines Kabels 46 mit dem Gerät oder System (nicht gezeigt) verbunden, in dem die mit dem Näherungsschalter gewonnenen Signale weiterverarbeitet werden.

**Patentansprüche**

1. Induktiver Näherungsschalter mit

- einer Spule,
- Mitteln zum Speisen der Spule mit einem periodischen Sendestrom der Periode T, und
- Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert werden,

welcher Näherungsschalter
**dadurch gekennzeichnet ist, dass**

(a) die Speisemittel dazu eingerichtet sind, der Spule (11) Sendestromimpulse zu liefern, deren Richtung periodisch wechselt, wobei jeweils

(b) in der ersten Hälfte einer Periode T der durch die Speisemittel an die Spule abgegebene Sendestrom in einer ersten Richtung und im wesentlichen nur während eines ersten Intervalls der Dauer T1 fliesst, die kleiner als T/2 ist, anschliessend während einem Zeitintervall (T1') abklingt und während der Restzeit (T2-T1') der ersten Hälfte der Periode T vernachlässigbar klein ist, und

(c) in der zweiten Hälfte der Periode T der durch die Speisemittel an die Spule abgegebene Sendestrom in einer der ersten entgegengesetzten Richtung und im wesentlichen nur während eines zweiten Intervalls der Dauer T3 fliesst, das kleiner als T/2 ist, anschliessend während einem Zeitintervall (T3') abklingt und während der Restzeit (T4-T3') der zweiten Hälfte der Periode T vernachlässigbar klein ist.

2. Induktiver Näherungsschalter gemäss Anspruch 1, **dadurch gekennzeichnet, dass** das erste bzw. das zweite Intervall des Sendestromes eine Dauer (T1 bzw. T3) haben, die wesentlich kleiner als die Hälfte der Periode T ist.

3. Induktiver Näherungsschalter gemäss Anspruch 1, **dadurch gekennzeichnet, dass** das erste und das zweite Intervall des Sendestromes die gleiche Dauer ( T1 = T3 ) haben.

4. Induktiver Näherungsschalter gemäss einem der vorangehenden Ansprüche, **dadurch gekennzeichnet, dass**

die Mittel zum Verarbeiten von Signalen dazu eingerichtet sind,
als ein erstes Eingangssignal und während eines ersten Zeitfensters der Dauer T2' eine erste in der Spule (11) induzierte Spannung (Ui1) zu empfangen, die von Strömen im erfassten Körper hervorgerufen wird, welche auf den Sendestrom zurückzuführen ist, der durch die Spule während des ersten Intervalls der Dauer T1 fliesst, wobei das erste Zeitfenster nach der Unterbrechung dieses Sendestromes beginnt und innerhalb der genannten Restzeit (T2-T1') der ersten Hälfte der Periode T liegt, und
als ein zweites Eingangssignal und während eines zweiten Zeitfensters der Dauer T4' eine zweite in der Spule (11) induzierte Spannung (Ui2) zu empfangen, die von Strömen im erfassten Körper hervorgerufen wird, welche auf den Sendestrom zurückzuführen ist, der durch die Spule während des zweiten Intervalls der Dauer T3 fliesst, wobei das zweite Zeitfenster nach der Unterbrechung dieses Sendestromes beginnt und innerhalb der genannten Restzeit (T4-T3') der zweiten Hälfte der Periode T liegt.

5. Induktiver Näherungsschalter gemäss Anspruch 4,
**dadurch gekennzeichnet, dass** sowohl das erste Zeitfenster T2' als auch das zweite Zeitfenster T4' sich bis an das Ende einer halben Periode T erstrecken.

**6.** Induktiver Näherungsschalter gemäss Anspruch 4,

**dadurch gekennzeichnet, dass** das erste und das zweite Zeitfenster die gleiche oder annähernd die gleiche Dauer T2' = T4' haben.

**7.** Induktiver Näherungsschalter gemäss Anspruch 4,

**dadurch gekennzeichnet, dass** die Mittel zum Verarbeiten von Signalen einen Polaritätsschalter (18) enthalten, der von periodischen Impulsen der Periode T/2 umgeschaltet wird, um das erste oder das zweite Eingangssignal während des ersten bzw. zweiten Zeitfensters zu invertieren bzw. um es nicht zu invertieren, so dass die Eingangssignale abwechselnd invertiert bzw. nicht invertiert werden, um ein Ausgangssignal zu erzeugen, dass aus einer Folge von Spannungsimpulsen gleicher Polarität besteht.

**7.** Induktiver Näherungsschalter gemäss Anspruch 4,

**dadurch gekennzeichnet, dass** das Ausgangssignal des Polaritätsschalters mittels eines Tiefpassfilters gemittelt und geglättet wird, um ein Ausgangssignal zu erzeugen, welches das Vorhandensein eines zu erfassenden Körpers signalisiert.

Fig. 1

EP 0 936 739 A1

Fig. 2

EP 0 936 739 A1

Fig. 3

Fig. 4

# EP 0 936 739 A1

**Europäisches Patentamt**

## EUROPÄISCHER RECHERCHENBERICHT

Nummer der Anmeldung

EP 98 81 0127

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,A | EP 0 492 029 A (DETRA SA) 1.Juli 1992 <br> * Spalte 1, Zeile 49 - Spalte 3, Zeile 35; Abbildungen 1-5 * <br> --- | 1 | H03K17/95 |
| A | US 4 544 892 A (KAUFMAN ALEXANDER A ET AL) 1.Oktober 1985 <br> * Spalte 3, Zeile 44 - Spalte 4, Zeile 34; Abbildung 3 * <br> ----- | 1 | |

**RECHERCHIERTE SACHGEBIETE (Int.Cl.6)**

H03K
G01V

Der vorliegende Recherchenbericht wurde für alle Patentansprüche erstellt

| Recherchenort | Abschlußdatum der Recherche | Prüfer |
|---|---|---|
| DEN HAAG | 14.Juli 1998 | D/L PINTA BALLE.., L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

11